# FASCICULE DE BREVET EUROPEEN

(11) **EP 0 382 803 B1**
(45) Date de publication et mention de la délivrance du brevet: **22.12.1993**
(21) Numéro de dépôt: 89906375.4
(22) Date de dépôt: 26.05.1989
(51) Int. Cl.: H01J 37/317, H01J 37/30, H01J 37/32, H01J 37/08

(54) **PROCEDE ET DISPOSITIF POUR L'ALIMENTATION, EN GAZ DE TRAITEMENT, D'UN REACTEUR SITUE DANS UNE ZONE SOUMISE A DES CHAMPS ELECTRIQUES ET/OU ELECTROMAGNETIQUES INTENSES**
VORRICHTUNG ZUR PROZESSGASZUFÜHRUNG IN EINEN REAKTOR, DIE SICH IN EINER ZONE MIT STARKEN ELEKTRISCHEN UND/ODER MAGNETISCHEN FELDERN BEFINDET, UND VERFAHREN
PROCESS AND DEVICE FOR SUPPLYING PROCESSING GAS TO A REACTOR LOCATED IN A ZONE SUBJECTED TO INTENSE ELECTRIC AND/OR ELECTROMAGNETIC FIELDS

(30) Priorité: 21.06.1988 FR 8808290
(43) Date de publication de la demande: 22.08.1990
(73) Titulaire: EFEREL S.A., F-78640 Neauphle-le-Chateau (FR)
(72) Inventeur: GENOU, Patrick, F-78960 Voisins-le-Bretonneux (FR)
(74) Mandataire: de Saint-Palais, Arnaud Marie
(86) Numéro de dépôt international: FR8900251
(87) Numéro de publication internationale: WO8912908

(56) Documents cités:
- US-A- 4 659 899
- Nuclear Instruments and methods in Physics Research, volume B6, No. 1/2, January 1985, Elsevier Science Publishers B.V. (North-Holland Physics Publishing Division), (Amsterdam, NL), O. Woodward et al.: "Computer automation of high current ion implanters", pages 146-153

## Description

L'invention concerne un procédé et un dispositif pour l'alimentation, en gaz de traitement, d'un réacteur situé dans une zone soumise à des champs électriques et/ou électromagnétiques intenses susceptibles de provoquer une ionisation dudit gaz.

Elle s'applique notamment, mais non exclusivement, à l'alimentation, en gaz de traitement, d'un dispositif de traitement par bombardement ionique, par exemple un implanteur ionique du type de ceux utilisés dans l'industrie des semiconducteurs pour incorporer des espèces chimiques ionisées sur des substrats en silicium en vue de leur dopage.

On sait que dans cet exemple, la génération, l'accélération et la focalisation des ions mettent en jeu des champs électriques considérables, nécessitant des sources de tensions de plusieurs dizaines de kilovolts.

C'est la raison pour laquelle, pour des raisons de sécurité, on est amené à isoler le réacteur (ou chambre d'ionisation) dans lequel s'effectue le traitement, ainsi que les éléments portés auxdites tensions situées dans son environnement dans une enceinte conductrice servant de blindage électrique et/ou électromagnétique qui constitue une barrière de potentiel entre son volume intérieur et son environnement extérieur.

Il s'avère qu'en raison de l'intensité des champs électriques intenses présents à l'intérieur de l'enceinte, il est impossible, en cours de traitement, d'admettre les gaz de traitement dans la chambre d'ionisation à partir de sources de gaz situées à l'extérieur de l'enceinte, notamment en raison de :
- l'impossibilité de faire passer des canalisations métalliques à travers l'enceinte (même dans le cas où ces canalisations seraient suffisamment isolées vis-à-vis de l'enceinte, ces canalisations seraient portées à des potentiels élevés et constitueraient des ponts de conduction électrique entre le volume intérieur de l'enceinte et son environnement extérieur),
- l'impossibilité de faire circuler les gaz dans des canalisations non conductrices, du fait que ces gaz s'ioniseraient et deviendraient conducteurs.

Compte tenu de ces problèmes, la solution actuelle consiste à utiliser des réserves de gaz de traitement de faible capacité (0,6 l en général) placées dans une boîte métallique ventilée, elle-même disposée à l'intérieur de l'enceinte conductrice et portée généralement au même potentiel que celui de la source haute tension qui alimente le réacteur (L'article Nuclear Instruments and Methods in Physics Research, vol. 6, n^{o} 1/2, janvier 1985, Elsevier Science Publishers B.V., O. Woodart et al., "Computer automation of high current ion implanters, pages 146-153 décrit un implanteur ionique dans lequel, au contraire, la réserve de gaz est mise à la terre).

Cette solution présente cependant plusieurs inconvénients majeurs :
- la nécessité d'un remplacement fréquent des bouteilles, ce remplacement impliquant l'ouverture de l'enceinte conductrice après avoir interrompu la tension d'alimentation haute tension et s'être assuré qu'il ne subsiste pas de charges électriques résiduelles à l'intérieur de l'enceinte, ces opérations ne pouvant être effectuées que lors d'un arrêt prolongé du réacteur ;
- des difficultés de manipulation dues, notamment, à la compacité du panneau de détente associé aux sources de gaz et à sa position à l'intérieur de l'enceinte ; et
- un risque de contamination et de corrosion des équipements situés à l'intérieur de l'enceinte au cours des manipulations, ces équipements étant, au demeurant, très onéreux.

L'invention a donc plus particulièrement pour but de supprimer tous ces inconvénients.

Elle propose, d'une façon générale, un procédé pour l'alimentation, en gaz de traitement, d'un réacteur fonctionnant à l'aide d'un courant haute tension et situé dans une zone soumise à des champs électriques et/ou électromagnétiques intenses susceptibles de provoquer une ionisation dudit gaz, ladite zone étant électriquement isolée de son environnement extérieur par au moins une paroi électriquement conductrice constituant une barrière de potentiel, ledit réacteur étant alimenté en gaz à l'aide d'au moins une capacité disposée à demeure à l'intérieur de ladite zone et portée audit potentiel haute tension,
Selon l'invention, ce procédé est plus particulièrement caractérisé en ce qu'il consiste à alimenter en gaz le susdit réacteur à l'aide de ladite capacité, dite capacité intermédiaire remplie de façon périodique à partir d'une source de gaz située à l'extérieur de ladite zone, pendant des interruptions du courant haute tension, grâce à au moins un conduit passant au travers de la paroi, ce conduit étant réalisé en matériau électriquement isolant au moins dans sa partie traversant ladite paroi.

En outre, chaque phase de remplissage de la capacité intermédiaire sera suivie par une obturation du susdit conduit dans une portion située dans la susdite zone, et de l'évacuation du susdit gaz au moins dans une partie du susdit conduit passant au travers de la susdite paroi.

Avantageusement, cette évacuation sera effectuée par un balayage de ladite partie, à l'aide d'un gaz non ionisable par les susdits champs.

Compte tenu de l'isolation électrique totale assurée par la partie en matière électriquement isolante du conduit, et grâce à la susdite évacuation du gaz de traitement, au moins dans cette partie, la capacité intermédiaire pourra être avantageusement portée à la haute tension, à l'image des réserves de gaz antérieurement utilisées.

Bien entendu, l'invention concerne également les dispositifs pour la mise en oeuvre du procédé précédemment défini.

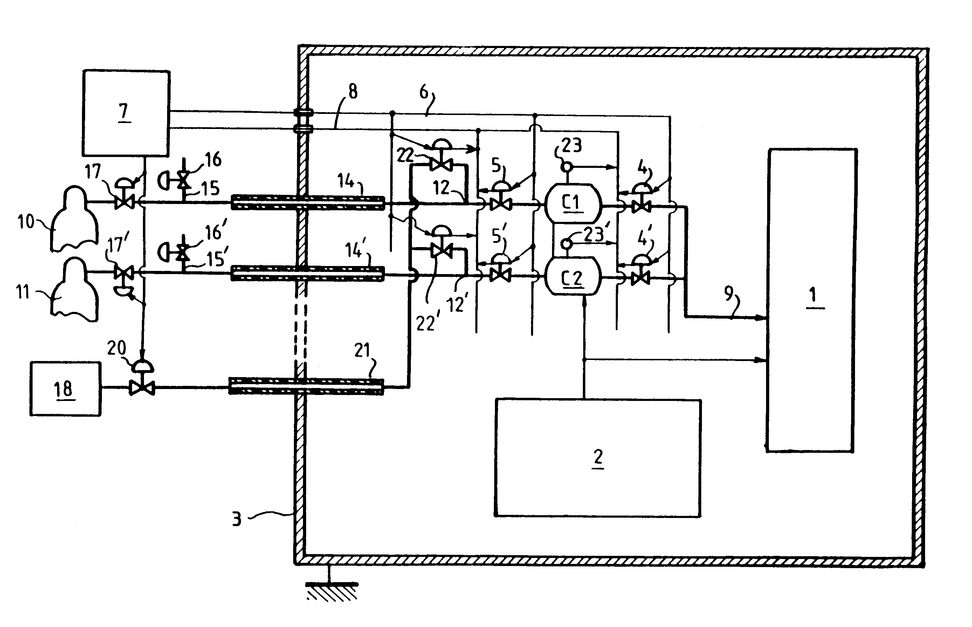

Un mode d'exécution d'un tel dispositif sera décrit ciaprès, à titre d'exemple non limitatif, avec référence au dessin annexé dans lequel :
La figure unique est une représentation schématique d'un dispositif d'alimentation, en gaz de traitement, d'une installation apte à effectuer des implantations ioniques sur des plaquettes de semi-conducteurs.

Dans cette installation, l'implanteur ionique 1 (représenté schématiquement par un bloc) est renfermé ainsi que son alimentation en haute tension 2, à l'intérieur d'une enceinte 3 an matière électriquement conductrice reliée à la terre.

Cette enceinte 3 permet donc d'assurer une isolation électrique et électromagnétique, par barrière de potentiel, entre son volume intérieur et son environnement extérieur.

L'alimentation de l'implanteur ionique 1 en gaz de traitement est assurée par une batterie de capacités intermédiaires C₁, C₂ (dont deux seulement ont été représentées) disposées à demeure à l'intérieur de l'enceinte 3 et dont les conduits d'entrée et de sortie sont équipés de vannes commandables à distance 4, 5-4', 5', par exemple à commande pneumatique, dont les circuits de commande 6 (par exemple les conduits d'admission et éventuellement d'échappement d'air comprimé) réalisés au moins partiellement en matériaux électriquement isolants, passent au travers de l'enceinte pour aboutir à un poste de commande 7. Sur cette figure, ces circuits de commande ont été regroupés en un faisceau unique représenté en traits fins. Ces vannes commandables 4, 5-4', 5' sont en outre équipées de capteurs permettant de détecter leur état (ouverture, fermeture), ces capteurs étant connectés au poste de commande, par exemple par des liaisons à fibres optiques 8 qui passent au travers de l'enceinte. Ici, également pour plus de clarté, ces liaisons ont été regroupées en un faisceau unique représenté en trait fin.

Les conduits de sortie des capacités intermédiaires C₁, C₂ sont connectés en aval des vannes 4, 4' à un collecteur commun 9 raccordé à la tubulure d'admission de gaz de traitement de l'implanteur 1.

Les conduits d'entrée des capacités C₁, C₂ sont, quant a eux, raccordés à des bouteilles de gaz de traitement 10, 11 situées à l'extérieur de l'enceinte 3 par des circuits d'admission comprenant chacun, en amont des vannes 5, 5' :
- des moyens de connexion 12, 12' d'un circuit de balayage dont le rôle sera défini ci-après,
- un tronçon de canalisation 14, 14' réalisé en un matériau électriquement isolant, situé dans une zone de ce circuit traversant l'enceinte 3,
- un orifice d'évent 15, 15' obturable par une vanne commandée 16, 16', et
- une vanne de commande d'admission de gaz de traitement 17, 17' située à la sortie de la bouteille 10, 11 (cette vanne pouvant éventuellement être incorporée à la bouteille 10, 11).

Dans cet exemple, le circuit de balayage comporte une source de gaz neutre sous pression 18, par exemple un générateur d'argon comprimé, située à l'extérieur de l'enceinte 3 dont le conduit de sortie équipé d'une vanne 20 passe au travers de l'enceinte 3 par l'intermédiaire d'un tronçon 21 en matière électriquement isolante, pour venir ensuite se raccorder aux moyens de connexion 12, 12', grâce à des tubulures de raccordement équipées chacune d'une vanne commandable à distance 22, 22'.

Ces vannes 22, 22' sont commandées à l'aide de circuits de commande similaires à ceux des vannes 4, 5-4', 5', qui passent au travers de l'enceinte pour venir se raccorder au poste de commande 7.

D'une façon similaire, l'état de ces vannes peut être détecté et transmis au poste de commande 7 par un système de transmission à fibres optiques.

Un même système de transmission peut en outre être utilisé pour transmettre des informations relatives à la pression des gaz contenus dans les capacités intermédiaires C₁, C₂ et qui émanent de capteurs de pression 23, 23' spécialement conçus à cet effet.

Pour éviter les phénomènes électrostatiques ou électrodynamiques dus à la présence, à l'intérieur de l'enceinte, de champs électriques intenses, les capacités intermédiaires C₁, C₂ sont portées au potentiel haute tension de l'alimentation 2.

Conformément au procédé selon l'invention, le remplissage des capacités intermédiaires C₁, C₂ s'effectue pendant les interruptions de la haute tension engendrée par l'alimentation 2, par exemple avant la mise en route et/ou les phases d'implantation effectuées par l'implanteur ionique 1.

Chacun de ces remplissages implique préalablement la fermeture des vannes 4, 4' de la vanne d'évent 16, 16' et des vannes de balayage 22, 22' puis l'ouverture des vannes 5, 5' et 17, 17'.

Le gaz de traitement provenant des bouteilles 10, 11 est alors injecté dans les capacités intermédiaires C₁, C₂ Jusqu'à ce que la pression dans ces dernières atteigne un seuil prédéterminé. A cet instant, les capteurs de pression 23, 23' transmettent au poste de commande 7 un signal de fin de remplissage. Celui-ci émet alors un signal de commande de fermeture des vannes 5, 5' et 17, 17' puis déclenche la phase de balayage.

Cette phase de balayage est alors obtenue en ouvrant les Vannes 22, 22' et 20 et les vannes d'évent 16, 16'.

Suite à cette ouverture, l'argon comprimé engendré par la source 18 est injecté dans les circuits d'admission juste en amont des vannes 5, 5'.

Ce gaz comprimé circulera à contre-sens dans les circuits d'admission en évacuant les gaz de traitement par l'orifice d'évent 15, 15'. Une fois cette phase de balayage effectuée, le poste de contrôle provoquera la fermeture des vannes 22, 22', 16, 16' et 20.

La haute tension pourra être rétablie en vue d'effectuer une phase d' implantation, le gaz de traitement étant alors admis dans l'implanteur à la suite de l'ouverture des vannes 4, 4'.

En raison des tronçons en matière électriquement isolante, et du fait que le gaz contenu dans ces derniers n'est pas ionisable par la haute tension délivrée par le générateur, aucun transfert d'énergie électrique ne pourra pas se produire entre le volume intérieur de l'enceinte et son environnement extérieur.

La sécurité de ce dispositif pourra être accrue en prévoyant un dispositif permettant d'interdire l'ouverture des vannes 17, 17' et 5, 5' et, en conséquence, toute possibilité d'accès du gaz de traitement dans les tronçons 14, 14', pendant les périodes d'application de la haute tension.

## Revendications

1. Procédé pour l'alimentation, en gaz de traitement, d'un réacteur (1) fonctionnant à l'aide d'un courant haute tension et situé dans une zone soumise à des champs électriques et/ou électromagnétiques intenses susceptibles de provoquer une ionisation dudit gaz, ladite zone étant électriquement isolée de son environnement extérieur par au moins une paroi électriquement conductrice (3) constituant une barrière de potentiel, ledit réacteur étant alimenté en gaz à l'aide d'au moins une capacité (C₁, C₂) disposée à demeure à l'intérieur de ladite zone et portée audit potentiel haute tension,
caractérisé en ce qu'il consiste à alimenter en gaz le susdit réacteur à l'aide de ladite capacité, dite capacité intermédiaire (C₁, C₂), remplie de façon périodique à partir d'une source de gaz (10, 11) située à l'extérieur de ladite zone, pendant des interruptions du courant haute tension, grâce à au moins un conduit passant au travers de la paroi (3), ce conduit étant réalisé en matériau électriquement isolant au moins dans sa partie traversant ladite paroi (3), et en ce que chaque phase de remplissage de la capacité intermédiaire (C₁, C₂) est suivie par une obturation du susdit conduit dans une portion située dans la susdite zone et de l'évacuation du susdit gaz au moins dans une partie du susdit conduit passant au travers de la susdite paroi (3).

2. Procédé selon la revendication 1,
caractérisé en ce que la susdite évacuation est effectuée par un balayage de la susdite partie à l'aide d'un gaz non ionisable par les susdits champs.

3. Procédé selon l'une des revendications 1 et 2,
caractérisé en ce que le susdit réacteur est un implanteur ionique.

4. Dispositif pour l'alimentation, en gaz de traitement, d'un réacteur (1) fonctionnant à l'aide d'un courant haute tension et situé dans une zone soumise à des champs électriques et/ou électromagnétiques intenses susceptibles de provoquer une ionisation dudit gaz, ladite zone étant électriquement isolée de son environnement extérieur par au moins une paroi électriquement conductrice (3) constituant une barrière de potentiel,
ledit dispositif comprenant au moins une capacité (C₁, C₂) disposée à demeure à l'intérieur de ladite zone et portée audit potentiel haute tension,
caractérisé en ce que ladite capacité, dite capacité intermédiaire (C₁, C₂), est connectée par sa sortie, au conduit d'admission en gaz de traitement du réacteur (1), par l'intermédiaire d'un conduit équipé d'une première vanne (4, 4') commandable depuis l'extérieur et, par son entrée, à une source de gaz de traitement située à l'extérieur par l'intermédiaire d'un conduit d'admission comprenant, dans ladite zone, une deuxième vanne (5, 5') commandable depuis l'extérieur, un tronçon (14, 14') réalisé en un matériau électriquement isolant qui s'étend dans au moins la portion du circuit traversant ladite paroi (3) et, dans sa partie extérieure à ladite zone, un orifice d'évent (15, 15') équipé d'un obturateur commandable (16, 16') puis une vanne (17, 17') commandant l'admission du gaz de traitement, ledit dispositif comprenant en outre un circuit de balayage comportant, à l'extérieur de ladite zone, une source de gaz non ionisable sous l'effet des susdits champs (18) connectée au circuit d'admission en gaz de traitement en un emplacement situé dans la susdite zone, en amont de la deuxième vanne (5, 5'), grâce à un conduit de balayage traversant la susdite paroi.

5. Dispositif selon la revendication 4,
caractérisé en ce que le susdit conduit de balayage comprend au moins une troisième vanne (22, 22') située à l'intérieur de la susdite zone, et commandable depuis l'extérieur.

6. Dispositif selon l'une des revendications 4 et 5,
caractérisé en ce qu'au moins un tronçon (21) du conduit de balayage passant au travers de la susdite paroi (3) est réalisé en un matériau électriquement isolant.

7. Dispositif selon la revendication 5,
caractérisé en ce que l'état (ouvert ou fermé) des susdites première, deuxième et troisième vannes (4, 4'-5, 5'-22, 22') est détecté par des capteurs respectifs reliés à un poste de commande (7) extérieur à la susdite zone par des lignes de transmission (6, 8) passant au travers de la susdite paroi (3).

8. Dispositif selon la revendication 7,
caractérisé en ce que les susdites lignes de transmission (6, 8) sont de type à fibres optiques.

9. Dispositif selon l'une des revendications 4 à 8,
caractérisé en ce que les susdites capacités intermédiaires (C₁, C₂) sont équipées de capteurs de pression (23, 23') aptes à transmettre, a un poste de commande (7) situé à l'extérieur de la susdite zone, un signal de fin de remplissage.

## Claims

1. Process for supplying, with processing gas, a reactor (1) operating by means of a high voltage current and situated in a zone subjected to intense electric and/or electromagnetic fields likely to cause ionization of said gas, said zone being insulated electrically from its outer environment by at least one electrically conducting wall (3) forming a potential barrier, said reactor being supplied with gas by at least one capacity (C₁, C₂) permanently disposed inside said zone and carried to said high voltage potential,
characterized in that it consists in supplying said reactor with gas by means of said capacity, said intermediate capacity (C₁, C₂), filled periodically from a gas source (10, 11) situated outside said zone, during interruptions of the high voltage current, by means of at least one pipeline passing through the wall (3), this pipeline being made from an electrically insulating material at least on its portion passing through said wall (3), and in that each phase of filling the intermediate capacity (C₁, C₂) is followed by closure of said pipeline in a portion situated in said zone, and evacuation of said gas at least in a portion of said pipeline passing through said wall (3).

2. Process according to claim 1,
characterized in that said evacuation is carried out by scavenging said portion with a gas which is not ionizable by said fields.

3. Process according to one of claims 1 and 2,
characterized in that said reactor is an ionic implanter.

4. Device for supplying, with processing gas, a reactor (1) operating by means of a high voltage current and situated in a zone subjected to intense electric and/or electromagnetic fields likely to cause ionization of said gas, said zone being insulated electrically from its outer environment by at least one electrically conducting wall (3) forming a potential barrier, said device comprising at least one capacity (C₁, C₂) disposed permanently inside said zone and carried to said high voltage potential,
characterized in that said capacity, said intermediate capacity (C₁, C₂), is connected by its output to the processing gas intake pipe of the reactor (1) through a pipeline equipped with a first valve (4, 4') which can be controlled from the outside and, by its input, to a processing gas source situated outside through an intake pipe comprising, in said zone, a second valve (5, 5') which can be controlled from outside, a section (14, 14') made from an electrically insulating material which extends through at least the portion of the circuit passing through said wall (3) and, in its part external to said zone, a vent orifice (15, 15') equipped with a controllable closure means (16, 16') then a valve (17, 17') controlling the intake of the processing gas, said device further comprising a scavenging circuit having, outside said zone, a source of gas which is not ionizable under the effect of said fields (18) connected to the processing gas intake circuit at a position situated in said zone, upstream of the second valve (5, 5') through a scavenging pipe passing through said wall.

5. Device according to claim 4,
characterized in that said scavenging pipe comprises at least a third valve (22, 22') situated inside said zone and controllable from outside.

6. Device according to one of claims 4 and 5,
characterized in that at least one section (21) of the scavenging pipe passing through said wall (3) is made from an electrically insulating material.

7. Device according to claim 5,
characterized in that the state (open or closed) of said first, second and third valves (4, 4'-5, 5'-22, 22') is detected by respective sensors connected to a control station (7) outside said zone by transmission lines (6, 8) passing through said wall (3).

8. Device according to claim 7,
characterized in that said transmission lines (6, 8) are of optical fibre type.

9. Device according to one of claims 4 to 8,
characterized in that said intermediate capacities (C₁, C₂) are equipped with pressure sensors (23, 23') adapted for transmitting an end of filling signal to a control station (7) situated outside said zone.

## Patentansprüche

1. Verfahren zur Speisung eines Reaktors (1) mit Behandlungsgas, der mit Hilfe eines Hochspannungsstroms arbeitet und sich in einer Zone befindet, die intensiven elektrischen und/oder elektromagnetischen Feldern ausgesetzt ist, welche eine Ionisierung des Gases hervorrufen können, wobei die Zone durch mindestens eine elektrisch leitende Wand (3), die eine Potentialschwelle darstellt, elektrisch von ihrer Aussenumgebung isoliert ist, wobei der Reaktor mit Hilfe mindestens eines Kondensators (C₁, C₂) mit Gas gespeist wird, der fest innerhalb dieser Zone angeordnet und auf das Hochspannungspotential gebracht ist,
dadurch gekennzeichnet, dass es darin besteht, den Reaktor mit Hilfe des Kondensators, genannt Zwischenkondensator (C₁, C₂) mit Gas zu versorgen, der periodisch ausgehend von einer ausserhalb der Zone angeordneten Gasquelle (10, 11) während Unterbrechungen des Hochspannungsstroms über mindestens einen durch die Wand (3) verlaufenden Kanal gefüllt wird, wobei dieser Kanal mindestens in seinem die Wand (3) durchquerenden Teil aus elektrisch isolierendem Material hergestellt ist, und dass jede Füllphase des Zwischenkondensators (C₁, C₂) von einem Verschluss des Kanals in einem Bereich, der sich in der Zone befindet, und vom Abzug des Gases mindestens in einem Teil des Kanals, der durch die Wand (3) verläuft, gefolgt wird.

2. Verfahren nach Anspruch 1,
dadurch gekennzeichnet, dass dieser Abzug durch ein Ausspülen dieses Teils mit einem durch die erwähnten Felder nicht ionisierbaren Gas durchgeführt wird.

3. Verfahren nach einem der Ansprüche 1 und 2,
dadurch gekennzeichnet, dass der Reaktor ein Ionenimplantierer ist.

4. Vorrichtung zur Speisung eines Reaktors (1) mit Behandlungsgas, der mit Hilfe eines Hochspannungsstroms arbeitet und sich in einer Zone befindet, die intensiven elektrischen und/oder elektromagnetischen Feldern ausgesetzt ist, welche eine Ionisierung des Gases hervorrufen können, wobei die Zone durch mindestens eine elektrisch leitende Wand (3), die eine Potentialschwelle darstellt, elektrisch von ihrer Aussenumgebung isoliert ist, wobei diese Vorrichtung mindestens einen Kondensator (C₁, C₂) aufweist, der fest innerhalb dieser Zone angeordnet und auf das Hochspannungspotential gebracht ist,
dadurch gekennzeichnet, dass der Kondensator, genannt Zwischenkondensator (C₁, C₂), über seinen Ausgang mit dem Einlasskanal des Reaktors (1) für Behandlungsgas über einen Kanal, der mit einem ersten, von aussen steuerbaren Ventil (4, 4') ausgestattet ist, und über seinen Eingang mit einer ausserhalb angeordneten Quelle von Behandlungsgas über einen Einlasskanal verbunden ist, der in dieser Zone ein zweites von aussen steuerbares Ventil (5, 5'), einen Abschnitt (14, 14') aus einem elektrisch isolierenden Material, der sich mindestens in dem die Wand (3) durchquerenden Abschnitt des Kreises erstreckt, und in seinem ausserhalb dieser Zone liegenden Bereich eine Lüftungsöffnung (15, 15'), die mit einer steuerbaren Verschlussvorrichtung (16, 16') ausgestattet ist, und dann ein Ventil (17, 17') aufweist, das den Einlass des Behandlungsgases steuert, wobei diese Vorrichtung weiter einen Spülkreis aufweist, der ausserhalb dieser Zone eine Quelle von unter dem Einfluss der erwähnten Felder (18) nicht ionisierbarem Gas aufweist, die über einen die Wand durchquerenden Spülkanal an einer Stelle mit dem Einlasskreis für Behandlungsgas verbunden ist, die sich in dieser Zone stromaufwärts vor dem zweiten Ventil (5, 5') befindet.

5. Vorrichtung nach Anspruch 4,
dadurch gekennzeichnet, dass der Spülkanal mindestens ein drittes Ventil (22, 22') aufweist, das sich innerhalb dieser Zone befindet und von ausserhalb steuerbar ist.

6. Vorrichtung nach einem der Ansprüche 4 und 5,
dadurch gekennzeichnet, dass mindestens ein Abschnitt (21) des Spülkanals, der durch die Wand (3) verläuft, aus einem elektrisch isolierenden Material hergestellt ist.

7. Vorrichtung nach Anspruch 5,
dadurch gekennzeichnet, dass der Zustand (offen oder geschlossen) des ersten, zweiten und dritten Ventils (4, 4' ; 5, 5' ; 22, 22') von Sonden erfasst wird, die je mit einer Steuerstation (7) ausserhalb der Zone über Übertragungsleitungen (6, 8) verbunden sind, die durch die Wand (3) verlaufen.

8. Vorrichtung nach Anspruch 7,
dadurch gekennzeichnet, dass die Übertragungsleitungen (6, 8) solche aus Glasfasern sind.

9. Vorrichtung nach einem der Ansprüche 4 bis 8,
dadurch gekennzeichnet, dass die Zwischenkondensatoren (C₁, C₂) mit Drucksonden (23, 23') ausgestattet sind, die zu einer ausserhalb der Zone angeordneten Steuerstation (7) ein Signal des Endes des Einfüllens übertragen können.
